# EUROPÄISCHE PATENTSCHRIFT

(11) **EP 1 527 394 B1**
(45) Veröffentlichungstag und Bekanntmachung des Hinweises auf die Patenterteilung: **07.11.2007**
(21) Anmeldenummer: 03709633.6
(22) Anmeldetag: 20.02.2003
(51) Int. Cl.: G06F 13/42, G01D 18/00

(54) **SENSOR UND VERFAHREN ZUR ÜBERWACHUNG WENIGSTENS EINES SENSORS**
SENSOR AND METHOD FOR MONITORING AT LEAST ONE SENSOR
CAPTEUR ET PROCEDE DE CONTROLE D'AU MOINS UN CAPTEUR

(30) Priorität: 01.08.2002 DE 10235161
(43) Veröffentlichungstag der Anmeldung: 04.05.2005
(73) Patentinhaber: ROBERT BOSCH GMBH, 70442 Stuttgart (DE)
(72) Erfinder: STEIGER, Eckard, 70195 Stuttgart (DE)
(86) Internationale Anmeldenummer: PCT/DE2003/000526
(87) Internationale Veröffentlichungsnummer: WO 2004/017215

(56) Entgegenhaltungen:
- EP-A- 0 745 864
- WO-A-98/20615
- DE-A- 3 121 645
- US-A- 4 464 653

## Beschreibung

### Stand der Technik

Die Erfindung geht aus von einem Sensor bzw. einem Steuergerät bzw. einem Verfahren zur Überwachung wenigstens eines Sensors nach der Gattung der unabhängigen Patentansprüche.

Aus WO 98/206 15 A2 ist es bekannt, einen intelligenten Sensor vorzusehen, der eine Temperaturkompensation aufweist. Die Temperaturkompensation wird dabei durch die Einstellung von Verstärkungsfaktoren erreicht. Aus DE 31 21 645 A1 ist es bekannt, Geberausgangssignale einzeln einem Komparator zur Überwachung von Grenzwerten zuzuführen. Damit kann die Art des Fehlers festgestellt werden. Dies kann dann in einem Fehlerspeicher abgespeichert werden. Der Ausfall von Gebern kann durch Hilfsspannungen kompensiert werden. Aus EP 745 864 A1 ist es ebenfalls bekannt, mittels eines Fensterkomparators das Ausgangssignal eines Sensors zu überwachen. In Abhängigkeit von dieser Überwachung steuert ein Controller Anzeigen an. Aus US 4, 464, 653 ist es bekannt, Brennraumsensoren vorzusehen, die digital ihre Sensorsignale zu einem Controller übermitteln. Dieser Controller kann eine Fehlfunktion des Sensors erkennen.

### Vorteile der Erfindung

Der erfindungsgemäße Sensor bzw. das erfindungsgemäße Steuergerät bzw. das erfindungsgemäße Verfahren zur Überwachung wenigstens eines Sensors mit den Merkmalen der unabhängigen Patentansprüche haben den Vorteil, dass ein differenziertes Fehlermuster mit einer bestimmten Fehlermeldung dem System, d.h. dem Steuergerät übermittelt wird und eine angepasste Reaktion erfolgen kann, und es vermieden wird, dass bei jedem Fehler eines Sensors die Folge ist, dass das Sensorsignal pauschal nicht genutzt werden darf bzw. dass das System auf einen dauerhaften Sensorfehler und damit auf einen Systemdefekt erkennt. Störungen, die keine bleibende Sensorschädigung bedeuten und möglicher Weise sogar auf zwar seltene, aber mögliche Betriebszustände zurückzuführen sind, können damit also nicht zu scharf geahndet werden. Beispiele hierfür sind die elektromagnetische Störeinkopplung und hammerschlagbedingte Vibrationen. Damit wird die Leistungsfähigkeit oder Sensititivät der Systeme verbessert, und es wird die Wahrscheinlichkeit eines Steuergerätefeldausfalls verringert. Insbesondere ist es durch die Erfindung möglich, mit einer Adaption und Applikation auf das jeweilige Zielsteuergerät und Fahrzeug besser auf die jeweils unterschiedlichen Systemanforderungen bzw. Kundenanforderungen hinsichtlich Auslöseparameter und Fehlermanagement einzugehen.

Damit lässt sich einerseits die Leistungsfähigkeit und die Robustheit des Gesamtsystems erhöhen, andererseits lassen sich Feldausfallraten reduzieren, da mit der tieferen Fehlermusterkenntnis nicht bei allen Fehlermustern auf einen Totalausfall erkannt werden muss. Außerdem ist die Erfindung deshalb vorteilhaft, weil in der Rückhaltesystementwicklungs- und Erprobungsphase die Fehlerfindung und Optimierung erleichtert werden kann. Der Einsatz der Erfindung ist jedoch auch in anderen automobilen Einsatzgebieten, in denen Sensoren eingesetzt werden, möglich und sinnvoll, insbesondere bei der Fahrdynamikregelung und in der Navigation.

Durch die in den abhängigen Ansprüchen aufgeführten Maßnahmen und Weiterbildungen sind vorteilhafte Verbesserungen der in den unabhängigen Patentansprüchen genannten Sensor, Steuergerät und Verfahren zur Überwachung wenigstens eines Sensor möglich.

Besonders vorteilhaft ist, dass die Statusbits, die die Fehlermoden anzeigen, aus verschiedenen sensorinternen Überwachungsmechanismen gebildet werden und nur solange bestehen bleiben, wie auf den zum Fehlerzustand gehörigen Betriebszustand erkannt wird. Damit ist zur systemseitigen Applikation des Sensors auch die Zeitinformation für jeden einzelnen Fehlermodus nutzbar. Damit wird eine genaue Analyse des Fehlers möglich, der mittels eines sogenannten Look-Up-Tables, also einer Tabelle, gelöst werden kann. Das vom Sensor übertragene Fehlermuster zum Steuergerät kann dann entsprechend im Prozessor des Steuergeräts ausgewertet werden. Insbesondere ist es damit möglich, dass das Steuergerät erkennt, ob es sich um einen dauerhaften Fehler handelt und wie schwerwiegend der Fehler ist.

Insbesondere von Vorteil ist, dass das Fehlermuster digital in einem 8-Bit-Wort, hier mit der Abkürzung MONI versehen, in einem 16-Bit-Rahmen übertragen wird. Mit unterschiedlichen Lesebefehlen lässt sich das MONI-Wort mit unterschiedlichen Fehleranzeigen beschreiben. Dadurch lässt sich die Anzahl der übertragbaren Fehlermoden erhöhen. Dabei sind in diesem Wort die Fehlerart oder -Moden über Flags gekennzeichnet. Es werden also verschiedene Fehlermoden und außergewöhnliche Betriebszustände, die erkannt wurden, durch dieses Wort angezeigt. Fehlermoden zeigen an, dass wenigstens ein Sensorbetriebsparameter außerhalb eines vorgegebenen Bereichs liegt.

Bei einer solchen Überwachung werden vorteilhafter Weise wenigstens eine Phasenregelschleife des Sensors und/oder wenigstens eine Steuerspannung auf einen vorgegebenen Bereich und/oder die Ausgangswerte von wenigstens einem Analog-Digital-Wandler auf einen vorgegebenen Bereich und/oder die Ein- und/oder Ausgangswerte von wenigstens einem Digital-Analog-Wandler auf einen vorgegebenen Bereich und/oder die Dynamikgrenzen von wenigstens einem Kapazitäts-Spannungswandler auf einen vorgegebenen Bereich und/oder wenigstens ein Offset-Regler auf einen vorgegebenen Bereich und/oder wenigstens ein Gleichtakt-Regler auf Verlassen eines vorgegebenen Bereich und/oder wenigstens eine Größe, die eine Sensor-Oszillation repräsentiert, auf einen vorgegbenen Bereich und/oder unzulässige Werte von wenigstens einem Zähler gemäß Festlegung überwacht. Wird ein Fehler oder ein außergewöhnlicher Betriebszustand erkannt, dann wird ein jeweiliger Wert in einem jeweiligen Register gesetzt. D.h. ein Fehlerregister wird mit einer logischen 1 belegt. Wird dieser Fehler oder dieser außergewöhnliche Betriebszustand nicht mehr erkannt, dann wird das jeweilige Register zurückgesetzt. Es wird also wieder eine logische 0 gesetzt.

Wenn mindestens ein Wert, der auf einen Fehler hinweist, auf 1 gesetzt wird, wird auch ein anderer Wert zu eins gesetzt. Damit wird es ermöglicht, über ein einziges Bit oder Flag anzuzeigen, ob auf irgendeinen sensorinternen Fehler erkannt wurde. Dieses Flag wird bei jeder regulären Sensorausgangswert-Übertragung als Statusinformation mit übertragen. Bei Bedarf, d.h. im Fall, dass der zusammenfassende Wert einen Fehlerzustand anzeigt, kann dann das detaillierte Fehlermuster durch die zur Verfügung stehenden Lesebefehle angefordert werden. Durch diese bedarfsabhängige Anforderung wird Übertragungs- und Verarbeitungskapazität eingespart. Die Zuordnung Lesebefehl Nr. 1, 2 ... zur Fehlerinformation ist im Wort MONI festgelegt. Hier werden zwei Lesebefehle verwendet. D.h. zwei 8-Bit-Worte an Fehlerinformation sind anzeigbar.

Weiter ist es von Vorteil, dass der Sensor selbst innerhalb des Gehäuses des Steuergeräts angeordnet ist. Dann sind der Sensor über die digitale Schnittstelle und der Prozessor des Steuergeräts vorzugsweise über SPI(Serial Peripherial Interface)-Leitungen miteinander verbunden.

### Zeichnung

Ausführungsbeispiele der Erfindung sind in der Zeichnung dargestellt und werden in der nachfolgenden Beschreibung näher erläutert.

Es zeigen
- Figur 1: ein Blockschaltbild des erfindungsgemäßen Sensors in einem erfindungsgemäßen Steuergerät und
- Figur 2: ein erfindungsgemäßes Datentelegramm.

### Beschreibung

Drehratensensoren, wie auch andere Sensoren, werden in zunehmendem Maße in elektronischen Rückhaltesystemen in der passiven Fahrzeugsicherheit eingesetzt. Drehratensensoren sind Kernbausteine zur Detektion von Überrollvorgängen und verwandten Unfallvorgängen, beispielsweise des Soil Trips.

Einige der in den Rückhaltesystemen eingesetzten Sensoren verfügen über eine sensorinterne Funktionsüberwachung, also einer sogenannten Monitoring-Funktion. Ein Fehler oder Störungszustand, dem unterschiedlichste Ursachen zu Grunde liegen können, wird, wenn er identifiziert ist, bei analogen Sensorschnittstellen zum System, einer Sensorplattform, einem Steuergerät, im allgemeinen einem Mikrokontroller oder einem Sicherheitshalbleiter, über ein Logiksignal (Fehler, kein Fehler) mitgeteilt.

Digitale Sensoren bieten die technisch relativ einfach umzusetzende Möglichkeit, verschiedene Fehler und Störungszustände über fest zugeordnete Bits in Datenworten dem System zu übermitteln. Dabei ist jedem Bit ein Fehlerflag zugeordnet, das wiederum einem sensorinternen Schaltungsblock bzw. einer sensorinternen Überwachungs- oder einer Messgröße zugeordnet ist. Die sensorinterne Überwachungsfunktion spricht im Allgemeinen an, wenn eine der verschiedenen überwachten sensorinternen Steuerspannungen oder Regelgrößen in die Grenzen ihres jeweiligen Dynamikbereiches kommen oder sich außerhalb durch designabhängiger Wertebereiche befinden oder Offsetwerte außerhalb zulässiger Bereiche sind oder eine Phasenregelschleife aus der Synchronisierung fällt oder Zähler auf Überlauf oder unzulässige Werte erkannt haben. Die Überwachung wird im Allgemeinen über Fensterkomparatoren oder über Bewertung des Analog-Digital-Wandler-Ausgangs oder Digital-Analog-Wandler-Eingangsworts durchgeführt. Die Ursachen sind also bezogen auf die Sensor-Auswerteschaltung-Funktionsblöcke vielfältig.

### Mögliche Ursachen für Störungs- oder Fehlerzustände:

Bei in automobilen System eingesetzten Drehratensensoren ist die prinzipbedingte Vibrations- bzw. mechanische Störempfindlichkeit eine charakteristische, in der Sensorapplikation zu berücksichtigende Eigenschaft. Soweit keine mechanische Dämpfung erfolgt, wird die Leistungsfähigkeit der Systeme limitiert. Ein mechanischer Dämpferaufbau bedeutet einen beträchtlichen Entwicklungs-, Kosten- und Fertigungsmehraufwand. Stöße oder starke Vibrationen können das Sensorelement so stark stören, dass die sensorinternen Regelungen für gewisse Zeit nicht mehr greifen und der Sensor außerhalb seines spezifizierten Funktionsbereichs liegt. Weitere Störmöglichkeiten sind beispielsweise elektromagnetische Störeinkopplungen. Ebenso können Fehler im Sensor selbst oder in der Applikationsbeschaltung die Systemfunktion beeinträchtigen. Die Auswirkungen sind je nach Drehratensensorfehler, Störungsart und auch je nach Applikationsumgebung des Sensors, das sind die Beschaltung, die Leiterplatte und der Fahrzeugaufbau, unterschiedlich.

Bisher wird die Drehratensensoren-Monitoring-Funktion systemseitig lediglich zur grundsätzlichen Fehlererkennung genutzt. D.h. ist der Sensor in Ordnung oder nicht. Das Rückhaltesystem unterscheidet hinsichtlich seiner Reaktion allenfalls über die Zeitdauer der Fehlermeldung, ob ein Ausfall des Drehratensensors vorliegt oder nicht. Eine Applikation im Sinne einer Abstimmung der jeweiligen Systemreaktion auf die unterschiedlichen Fehlermeldungen findet mangels solcher nicht statt.

Da systemseitig keine Klassifizierung verschiedener Fehlermuster erfolgt und auch nicht die Applikationsumgebung einfließt, muss nach dem Prinzip "Annahme des Worst Case" vorgegangen werden. Ein über die Überwachungsfunktion als fehlerhaft identifizierter Zustand hat zur Folge, dass das Sensorsignal nicht genutzt werden darf, bzw. dass das System auf einen dauerhaften Sensorfehler und damit auf einen Systemdefekt erkennt. Störungen, die keine bleibende Sensorschädigung bedeuten und möglicherweise auf zwar seltene aber mögliche Betriebszustände zurück zu führen sind, werden also im Allgemeinen zu scharf geahndet. Das limitiert die Leistungsfähigkeit oder Sensibilität der Systeme oder erhöht die Wahrscheinlichkeit eines möglicherweise nicht notwendigen Steuergerät-Feldausfalls.

Erfindungsgemäß wird daher vom Sensor zum System, vorzugsweise einem Prozessor des Steuergeräts, ein Fehlermuster übertragen, das die Kombination verschiedener Fehlermoden aufweist und so dem System eine genaue Information über die Fehlerart und -ursache übermittelt. Damit ist dann eine angepasste Reaktion des Systems auf diesen Fehler möglich.

Bereits in der Entwicklungs- und Applikationsphase von Rückhaltesystemelektronik-Systemen werden die Fehlermuster, die bei unterschiedlichen Fehler- und Störungsursachen auftreten, erfasst. Das System kann mit der Verfügbarkeit eines Look-Up-Tables auf das jeweilige Fehlermuster angemessen reagieren.

Praktische Voraussetzung zur Umsetzung der Erfindung ist eine digitale Sensorschnittstelle. Nur damit lassen sich mit vertretbarem Aufwand eine größere Anzahl unterschiedlicher Fehler und Störungsmoden bzw. Muster und auch deren Kombinationen dem System übermitteln. Als beispielhafte Schnittstelle wird hier die bidirektionale SPI (Serial Peripherial Interface) verwendet. Beispielhaft sind dabei zum Auslesen der unterschiedlichen Fehlermoden zwei Befehle RD_MONITOR_I und RD_MONITOR_II vorgesehen, wobei die Moden selbst über Flags im jeweils rückübermittelten Wort MONI gekennzeichnet sind. Dabei bedeutet beispielsweise das Wort mit 8 Nullen, dass die überwachten Sensorparameter innerhalb spezifizierter Betriebsbereiche liegen und kein außergewöhnlicher Betriebszustand vorliegt. Durch Codierung können folgende Fehler indiziert werden:

Der Kapazitäts-Spannungswandler, bei dem die Messgröße über das Sensorprinzip in eine Kapazität bzw. eine Kapazitätsänderung abgebildet wird, ist außerhalb seines vorgegebenen Bereichs, der Wert am Analog-Digital-Wandler im Antriebspfad, es handelt sich hierbei um einen oszillierenden Sensor, ist außerhalb seines vorgegebenen Bereichs, die Phasenregelschleife ist nicht synchronisiert, der Offset-Regler ist außerhalb seines vorgegebenen Bereichs, der Summenwert und/oder der Differenzwert des Gleichtaktregelkreises im Antriebskreis und/oder im Detektionskreis ist außerhalb seines vorgegebenen Bereichs, die Amplitude der Sensoroszillation ist außerhalb ihres vorgegebenen Bereichs. Der Antriebskreis eines Drehratensensors dient zur Erzeugung einer definierten also im allgemeinen geregelten Schwingungs- oder Rotationsbewegung, über die nach beispielsweise dem Drehimpulserhaltungsprinzip bei anliegender Drehrate ein messbarer Effekt, beispielsweise eine Auslenkung einer mikromechanischen Struktur in othogonaler Richtung zu dieser Bewegung erzeugt wird. Im Detektionskreis erfolgt die Messung bzw. Erfassung und Verarbeitung dieses Effekts.

Zusätzlich zu diesen Fehleranzeigen kann als ein außergewöhnlicher Betriebszustand indiziert werden, wenn der anliegende Drehratenwert den Messbereich des Sensors über- bzw. unterschreitet und der Wert auf den maximal bzw. minimal darstellbaren abgebildet werden muss.

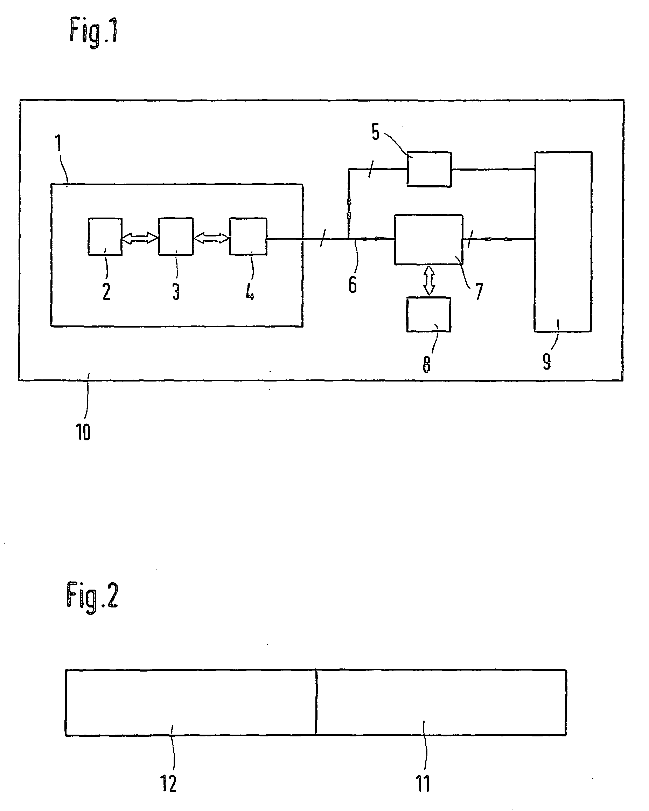

Figur 1 zeigt in einem Blockschaltbild den erfindungsgemäßen Sensor und das erfindungsgemäße Steuergerät. In einem Steuergerät 10 befindet sich ein Sensor 1, der über eine digitale Leitung 6 mit einem Prozessor 7 verbunden ist. Der Prozessor 7 ist über einen Datenein-/Ausgang mit einem Speicher 8 verbunden. Über einen Datenausgang ist der Prozessor 7 mit dem Rest des Rückhaltesystems 9 verbunden. An der digitalen Leitung 6 kann ein sogenannter Sicherheitshalbleiter 5, das ist ein weiterer Prozessor oder ein Überwachungsschaltkreis, angeschlossen sein, der die Sensorausgangswerte ebenfalls bewertet und Einfluss auf die Freigabe von Rückhaltemitteln nehmen kann. Im Sensor 1 befindet sich ein Sensorelement 2 zur Aufnahme einer Messgröße, beispielsweise von Drehraten bzw. Drehbeschleunigungen. Bei dem Sensorelement kann es sich damit vornehmlich um eine mikromechanische Sensorstruktur, bei der Antrieb und Detektion kapazitiv erfolgen, handeln. Das Sensorelement 2 ist an einen Funtkions- und Überwachungsbaustein 3 angeschlossen. Hier können die Kapazitäts-Spannungswandlung, die Analog-Digital-Wandlung des Sensorsignals, Antrieb und Regelung der Sensoroszillation und auch die sensorinternen Überwachungs- und Monitoringfunktionen erfolgen. Der Funktions- und Überwachungsbaustein 3 ist über einen Datenausgang mit einem Senderbaustein 4 verbunden. Der Senderbaustein 4 ist an die digitale Leitung 6 angeschlossen, die hier als eine sogenannte SPI(Serial Peripherial Interface)-Leitung ausgebildet ist.

Der Funktions- und Überwachungsbaustein 3 übernimmt also auch Überwachungs- bzw. Monitoring-Funktionen im Sensor 1. Die Messwerte werden an den Senderbaustein 4 weitergegeben. In einer vom Sensorschaltungstakt vorgegebenen Taktrate wird das Fehlermuster laufend aktualisiert und kann laufend abgefragt werden. In dieses Fehlermuster gehen die Messwerte im Sensor 1 ein.

Figur 2 zeigt schematisch einen Datenrahmen des angeforderten MISO-Wortes aus 16 Bit, der sich in einen ersten Teil 12 und in einen zweiten Teil 11 aufteilt. Im zweiten Teil 11 wird das jeweilige Fehlerwort 11 (MONI) übertragen. Es sind hier zwei Fehlerworte übertragbar, die mit unterschiedlichen MOSI-Befehlen ausgelesen werden können. Dies kann zyklisch erfolgen oder nur bei Bedarf. Dieser Bedarf wird in der Standarddrehratenübertragun durch das Setzen eines Bits, das einen nicht regulären Betriebszustand indiziert, angezeigt. Dieses Bit wird dann gesetzt, wenn auf wenigstens einen indizierbaren Fehlerfall erkannt wird.

Der Sensor 1 kann sich alternativ auch außerhalb des Steuergeräts 10 befinden. Anstatt nur eines Sensors 1 sind auch mehrere Sensoren auch unterschiedlicher Art einsetzbar und überwachbar. Neben dem hier angesprochenen Rückhaltesystem sind auch andere Fahrzeugsysteme für diese Erfindung geeignet, beispielsweise ein Fahrdynamiksystem oder ein Navigationssystem.

## Patentansprüche

1. Sensor mit einem Sensorelement (2) und wenigstens einer digitalen Schnittstelle (5), wobei Mittel (6) zur Übertragung eines Fehlermusters über die wenigstens eine digitale Schnittstelle (5) vorhanden sind, **dadurch gekennzeichnet, dass** der Sensor einen Funktions- und Überwachungsbaustein (3) für eine Überwachungs- oder Monitoringfunktion zur Erzeugung von Messwerten aufweist, wobei ein Senderbaustein (5) die Messwerte im Fehlermuster als ein Datenwort versendet, so dass das Fehlermuster verschiedene Fehlermoden aufweist.

2. Sensor nach Anspruch 1, **dadurch gekennzeichnet, dass** für das Fehlermuster ein 8-Bit-Datenwort (MONI) in einem Datentelegramm vorgesehen ist.

3. Sensor nach Anspruch 2, **dadurch gekennzeichnet, dass** zur Erzeugung der Fehlermeldung Mittel (4) zur Überwachung wenigstens einer Phasenregelschleife des Sensors und/oder wenigstens einer Steuerspannung auf einen ersten vorgegebenen Bereich und/oder der Ausgangswerte von wenigstens einem Analog-Digital-Wandler auf einen zweiten vorgegebenen Bereich und/oder Ausgangswerte von wenigstens einem Digital-Analog-Wandler auf einen dritten vorgegebenen Bereich und/oder Dynamikgrenzen von wenigstens einem Kapazitäts-Spannungswandler auf einen vierten vorgegebenen Bereich und/oder wenigstens eines Offset-Reglers auf einen fünften vorgegebenen Bereich und/oder wenigstens eines Gleichtaktreglers auf Verlassen eines sechsten vorgegebenen Bereichs und/oder wenigstens einer Größe, die eine Sensoroszillation repräsentiert, auf einen siebten vorgegebenen Bereich und/oder unzulässiger Werte von wenigstens einem Zähler gemäß Festlegung vorhanden sind, wobei bei einem Fehler ein jeweiliger Wert in einem jeweiligen Register abspeicherbar ist.

4. Sensor nach Anspruch 3, **dadurch gekennzeichnet, dass** nach einem Ende des jeweiligen Fehlers das jeweilige Register zurückgesetzt wird.

5. Verfahren zur Überwachung wenigstens eines Sensors (1), wobei der wenigstens eine Sensor (1) ein Fehlermuster zu einem Prozessor (7) überträgt, **dadurch gekennzeichnet, dass** ein Funktions- und Überwachungsbaustein (3) für eine Überwachungs- oder Monitoringfunktion Messwerte erzeugt, dass ein Senderbaustein (5) die Messwerte im Fehlermuster als ein Datenwort versendet, so dass das Fehlermuster verschiedene Fehlermoden aufweist.

6. Verfahren nach Anspruch 7, **dadurch gekennzeichnet, dass** das Sensorsignal für ein Rückhaltesystem (9) verwendet wird.

7. Verfahren nach Anspruch 7 oder 8, **dadurch gekennzeichnet, dass** das Sensorsignal einem Fahrdynamiksystem zugeführt wird.

## Claims

1. Sensor having a sensor element (2) and at least one digital interface (5), means (6) being provided for the purpose of transmitting an error pattern via the at least one digital interface (5), **characterized in that** the sensor has a function and monitoring module (3) for a monitoring function for the purpose of generating measured values, a transmitter module (5) sending the measured values in the error pattern in the form of a data word, with the result that the error pattern has different error modes.

2. Sensor according to Claim 1, **characterized in that** an 8-bit data word (MONI) is provided for the error pattern in a data message.

3. Sensor according to Claim 2, **characterized in that**, in order to generate the error message, means (4) are provided for the purpose of monitoring at least one phase locked loop of the sensor and/or at least one control voltage with respect to a first predefined range and/or the output values from at least one analogue/digital converter with respect to a second predefined range and/or output values from at least one digital/analogue converter with respect to a third predefined range and/or dynamic limits of at least one capacitance/voltage converter with respect to a fourth predefined range and/or at least one offset controller with respect to a fifth predefined range and/or at least one common-mode controller with respect to leaving a sixth predefined range and/or at least one variable, which represents a sensor oscillation, with respect to a seventh predefined range and/or impermissible values from at least one counter, in accordance with the stipulation, a respective value being able to be stored in a respective register in the case of an error.

4. Sensor according to Claim 3, **characterized in that** the respective register is reset after the end of the respective error.

5. Method for monitoring at least one sensor (1), the at least one sensor (1) transmitting an error pattern to a processor (7), **characterized in that** a function and monitoring module (3) generates measured values for a monitoring function, **in that** a transmitter module (5) sends the measured values in the error pattern in the form of a data word, with the result that the error pattern has different error modes.

6. Method according to Claim 7, **characterized in that** the sensor signal is used for a restraint system (9).

7. Method according to Claim 7 or 8, **characterized in that** the sensor signal is supplied to a vehicle dynamics system.

## Revendications

1. Capteur comportant au moins un élément de capteur (2) et au moins une interface numérique (5), et des moyens (6) pour transmettre un motif de défaut par l'interface numérique (5),
**caractérisé en ce que**
le capteur comporte un composant de fonction et de surveillance (3) pour une fonction de surveillance ou de contrôle pour générer des valeurs de mesure,
un composant émetteur (5) émettant des valeurs de mesure selon le motif de défaut comme un mot de données de façon que le motif de défaut corresponde à différents modes de défauts.

2. Capteur selon la revendication 1,
**caractérisé en ce que**
le motif de défaut est un mot de données à 8 bits (MONI) dans un télégramme de données.

3. Capteur selon la revendication 2,
**caractérisé en ce que**
pour générer un message de défaut, il y a des moyens pour surveiller au moins une boucle de régulation de phase du capteur et/ou au moins une tension de commande dans une première plage prédéfinie et/ou les valeurs de sortie d'au moins un convertisseur analogique/numérique sur une seconde plage prédéfinie et/ou des valeurs de sortie d'au moins un convertisseur numérique/analogique sur une troisième plage prédéfinie et/ ou des limites dynamiques d'au moins un convertisseur de tension-capacité pour une quatrième plage prédéfinie et/ou au moins un régulateur de décalage sur une cinquième plage prédéfinie et/ou au moins un régulateur de synchronisme lorsqu'on quitte une sixième plage prédéfinie et/ou au moins une grandeur qui représente une oscillation de capteur sur une septième plage prédéfinie et/ou des valeurs non autorisées d'au moins un compteur selon des constatations, et en cas de défaut, une valeur respective est enregistrée dans un registre respectif.

4. Capteur selon la revendication 3,
**caractérisé en ce qu'**
le registre correspondant est remis à l'état initial à la fin du défaut respectif.

5. Procédé de surveillance d'au moins un capteur (1) selon lequel au moins ce capteur (1) transmet un motif de défaut à un processeur (7),
**caractérisé par**
un composant de fonction et de surveillance (3) pour générer les valeurs de mesure de fonction de surveillance ou de contrôle, un composant émetteur (5) émettant les valeurs de mesure dans le motif de défaut sous la forme d'un mot de données pour que le motif de défaut présente différents modes de défauts.

6. Procédé selon la revendication 7,
**caractérisé en ce que**
le signal de capteur est utilisé pour un système de retenue (9).

7. Procédé selon la revendication 7 ou 8,
**caractérisé en ce que**
le signal de capteur est appliqué à un système de dynamique de roulage.
